# EUROPÄISCHE PATENTSCHRIFT

(11) **EP 0 883 176 B1**
(45) Veröffentlichungstag und Bekanntmachung des Hinweises auf die Patenterteilung: **17.11.2004**
(21) Anmeldenummer: 98108840.4
(22) Anmeldetag: 15.05.1998
(51) Int. Cl.: H01L 23/40, H01L 23/60

(54) **Kühlblechverbindungsklammer für Leistungshalbleiter**
Cooling fin with clip for power semiconductor
Ailette de refroidissement avec attache de serrage pour semiconducteur de puissance

(30) Priorität: 03.06.1997 DE 19723270
(43) Veröffentlichungstag der Anmeldung: 09.12.1998
(73) Patentinhaber: Patent-Treuhand-Gesellschaft für elektrische Glühlampen mbH, 81543 München (DE)
(72) Erfinder: Kiermeier, Theodor, 81475 München (DE); Lecheler, Reinhardt, 86633 Neuburg an der Donau (DE)

(56) Entgegenhaltungen:
- EP-A- 0 622 983
- DE-A- 3 331 207
- DE-U- 29 718 763
- US-A- 4 845 590
- US-A- 5 396 404

## Beschreibung

### Technisches Gebiet

Die Erfindung bezieht sich auf das Gebiet der Montage von elektronischen und mechanischen Bauelementen einer Schaltung auf einer Montageplatine, beispielsweise Leiterplatte. Sie befaßt sich dabei mit der Verbindung von Leistungshalbleitern mit zusätzlichen Kühlblechen zur Aufnahme der in den Leistungshalbleitern entstehenden Verlustwärme und zum Abführen dieser Wärme durch Wärmeleitung und durch Wärmestrahlung der relativ großen Oberfläche des Kühlblechs.

### Stand der Technik

Es ist bekannt, die mechanische und über den mechanischen Kontakt auch thermische Verbindung zwischen den Leistungshalbleitern und Kühlblechen durch die Federkraft einer Verbindungsklammer herzustellen. Dazu werden eine Fläche eines Leistungshalbleiters (eine Kühlfahne und ähnliche integrale Bestandteile werden hier und im folgenden zum Halbleiter gehörend aufgefaßt) und die entsprechende Fläche des Kühlblechs planar aneinander gelegt und durch die übergestülpte Klammer zusammengedrückt und - gehalten. Die Leistungshalbleiter stehen dabei im allgemeinen im wesentlichen senkrecht auf der Montageplatine. In vielen Fällen treten auf einer Montageplatine zwei oder mehr Leistungshalbleiter in unterschiedlichen Montagepositionen auf, die einzeln mit einem Kühlblech verbunden werden müssen.

Das Dokument US-A-4 845 590 offenbart eine Vorrichtung mit einem als Wärmesenke wirkenden Gehäuse, einer Schaltungsplatine, auf der eine Vielzahl elektronischer Bauteile in zwei zueinander parallelen Reihen angeordnet ist, zwei länglichen Trägern, wobei jeder Träger einer der beiden Bauteile-Reihen zugeordnet ist und die elektronischen Bauteile der jeweiligen Reihe stützt sowie einem im wesentlichen flächigen, konkav gebogenen Federelement, das zwischen den beiden Trägern derart angeordnet ist, dass es die Kühlfläche jedes elektronischen Bauteils gegen eine Wand des Gehäuses drückt. Das Federelement ist als streifenförmiger Grundkörper ausgebildet, vom dem rechteckige Finger ausgehen, wobei jedem elektronischen Bauteil einer dieser federnden Finger zugeordnet ist.

### Darstellung der Erfindung

Der Erfindung liegt das technische Problem zugrunde, den Montageschritt der Verbindung zwischen Leistungshalbleitern und Kühlblechen zu vereinfachen.

Erfindungsgemäß wird dieses Problem gelöst durch ein Verfahren zur Verbindung zumindest eines Kühlblechs mit zumindest zwei mit ihrer größten Fläche in verschiedenen Ebenen liegenden, im wesentlichen senkrecht auf einer Montageplatine montierten Leistungshalbleitern, bei dem das Kühlblech und eine jeweilige Fläche der Leistungshalbleiter durch die Federkraft einer Klammer planar aneinander gedrückt werden, wobei die Verbindung mit nur einer Klammer erfolgt, die Halteabschnitte für jeweils einen Leistungshalbleiter und einen Verbindungsabschnitt zwischen den Halteabschnitten aufweist, dadurch gekennzeichnet, daß die Klammer zumindest zwei Halteabschnitte mit je zwei Schenkeln aufweist, die geeignet sind zum planaren Aneinanderdrücken einer Fläche jeweils eines von zumindest zwei mit ihrer größten Fläche in verschiedenen Ebenen liegenden, im wesentlichen senkrecht auf einer Montageplatine montierten Leistungshalbleitern und eines Kühlblechs zwischen den Schenkeln des Halteabschnitts und mit einem die Halteabschnitte verbindenden Verbindungsabschnitt, der sich in einer zu den Schenkeln der Halteabschnitte im wesentlichen senkrechten Ebene erstreckt, sowie durch eine elektronische Baugruppe (d.h. auf und mit einer Montageplatine) mit zumindest zwei Leistungshalbleitern und einem Kühlblech und mit einer das Kühlblech und die Leistungshalbleiter aneinander drückenden Klammer der soeben beschriebenen Art.

Für zwei oder mehr nicht koplanar angeordnete Leistungshalbleiter findet eine einzige gemeinsame Klammer Verwendung. Dazu weist die Klammer neben einem Halteabschnitt für jeden Leistungshalbleiter einen Verbindungsabschnitt auf, der den Abstand und/oder Winkel zwischen den Halteabschnitten überbrückt und damit die leichte Handhabbarkeit der Klammer als Ganzes herstellt. Der Verbindungsabschnitt erlaubt gegenüber einer einfachen Klammer ohne Verbindungsabschnitt, die nur aus einem Halteabschnitt beispielsweise in einer U-Form besteht, die Verwendung der erfindungsgemäßen Klammer also auch für zwei oder mehr (bezüglich ihrer größten Fläche) nicht in einer Ebene liegende Leistungshalbleiter. Bei einer konventionellen (jedoch dabei verlängerten oder verbreiterten) Klammerstruktur wäre eine Verbindung dieser Leistungshalbleiter mit ihren jeweiligen Kühlblechen mit einer einzigen gemeinsamen Klammer nicht möglich.

Auf der U-Form einer konventionellen Klammer aufbauend kann die erfindungsgemäße Klammer dabei in einer einfachen und praktischen Geometrie aufgebaut sein aus zwei U-förmigen Halteabschnitten, die durch einen - aus seitlicher Ansicht der U-Form - im wesentlichen senkrecht zu den Halteabschnittschenkeln verlaufenden Verbindungsabschnitt zusammengehalten sind.

Durch die Verwendung einer einzigen Klammer für zwei oder mehrere Leistungshalbleiter wird der Montageaufwand wesentlich reduziert, weil weniger Teile am Montageplatz bevorratet und bei der Montage selbst gehalten, bewegt und aufeinander justiert werden müssen.

Die Vorteile der Erfindung betreffen also im wesentlichen ein hinsichtlich der Verbindung zwischen den Leistungshalbleitern und den Kühlblechen vereinfachtes Herstellungsverfahren und damit eine etwas kostengünstiger herzustellende elektronische Baugruppe insgesamt. Die erläuterten erfindungsgemäßen Merkmale betreffen dabei das Montageverfahren einerseits und die entsprechend ausgestaltete Klammer andererseits sowie die entsprechend hergestellte elektronische Baugruppe (d.h. Schaltung auf und mit der Platine).

Wenn bei der beschriebenen Form der Klammer der Verbindungsabschnitt gegenüber der Montageplatine einen gewissen Höhenabstand einhält, insbesondere also gegenüber dem dieser zugewandten Ende der Halteabschnitte etwas zurückversetzt verläuft, wird durch die im Gegensatz zum Stand der Technik auch zwischen den Leistungshalbleitern verlaufende Klammer keine geometrische Einschränkung der Montagemöglichkeiten von Bauteilen der Schaltung herbeigeführt. Durch dieses Zurückversetzen ergibt sich ein Zwischenbereich zwischen dem Verbindungsabschnitt und dem jeweiligen Halteabschnitt, der z.B. das U sozusagen (zumindest ansatzweise) zum querliegenden S ergänzt.

Die dann unter dem Verbindungsteil liegenden Bauteile sind durch die Klammer nach oben hin in gewissem Umfang abgedeckt. Diese Abdeckung kann außer einem mechanischen Schutz auch für eine Verminderung leitungsgebundener Funkstörungen wesentlich sein. Dazu wird die Klammer auf ein gegenüber der Umgebung im wesentlichen konstantes Potential gelegt.

Bei Halbbrückenschaltungen, wie sie insbesondere in elektronischen Konvertern für Niedervolt-Halogenglühlampen und in elektronischen Vorschaltgeräten für Leuchtstofflampen verwendet werden, ist zu diesem Zweck die Klammer vorteilhaft mit der Kühlfahne des "oberen" Halbbrükkentransistors, d.h. mit dem auf dem Potential des Gleichrichters bzw. der Gleichspannungsversorgung liegenden Kollektor, elektrisch leitend verbunden. Dadurch wirkt die Klammer und das oder die Kühlbleche als Abschirmfläche bezüglich hochfrequenten Störpotentialen. Gegenüber dem Kollektor des "unteren" Halbbrückentransistors, d.h. gegenüber dem Potential des Verbindungspunktes der beiden Halbbrückentransistoren, ist die Klammer und das Kühlblech hingegen elektrisch isoliert (etwa mit einer Folie, die die thermische Leitung wenig beeinflußt). Der Grund hierfür ist der folgende. Das Potential des Verbindungspunktes schwankt hochfrequent im Takte der Halbbrücke. Die mit diesem Potential verbundene Kühlfahne des unteren Halbbrückentransistors stellt folglich ein Störpotential gegenüber der Umgebung dar. Würde diese Störpotentialfläche durch Kontaktierung mit dem Kühlblech bzw. der Klammer vergrößert, so stiegen die unerwünschten Funkstörungen erheblich. Der Vollständigkeit halber sei erwähnt, daß selbstverständlich der Kollektor (bzw. Kühlfahne) mindestens einer der beiden Halbbrückentransistoren von der metallischen Klammer elektrisch isoliert sein muß. Anderfalls wäre der obere Halbbrückentransistor mittels der Klammer kurzgeschlossen. Allerdings wirkt die Klammer nur bei der oben beschriebenen erfindungsgemäß korrekten Kontaktierung als Abschirmung. Nur in diesem Fall werden die sonst üblichen Funkstörungen weiter verringert.

Die Abschirmfunktion wird durch eine flächige Ausführung des Verbindungsabschnitts betont. Dabei kann durch die größere abstrahlende Fläche der Klammer auch die Funktion des oder der Kühlbleche wirksam unterstützt werden. Es ist auch möglich, ganz auf separate Kühlbleche zu verzichten und nur mit integrierten Bestandteilen der Klammer, nämlich als Kühlblech gestalteten Teilen der Halteabschnitte oder des Verbindungsabschnitts auszukommen. Dazu müssen die entsprechenden Abschnitte in erster Linie großflächig ausgeführt werden. Ferner können beispielsweise großflächige Außenschenkel der Halteabschnitte mit den bei Kühlblechen üblichen Steckfüßen versehen sein. Durch diese integrierte Ausführung wird die Zahl der Bauteile weiter reduziert und die Montage zusätzlich vereinfacht.

Nach einer weiteren vorteilhaften Ausgestaltung der Erfindung kann der Abstand zwischen den Halteabschnitten etwas Übermaß aufweisen, also gegenüber dem durch den Abstand der Leistungshalbleiter vorgegebenen Abstand, gegebenenfalls unter Berücksichtigung der Kühlblechstärke, etwas zu groß sein. Dann wird der Verbindungsabschnitt bei der Montage als Feder wirksam. Diese Funktion kann er vor allem wegen seiner im allgemeinen größeren Länge gegenüber den Federeigenschaften konventioneller Klammern oder der Halteabschnitte besser ausüben. Durch das Maß der bereits beschriebenen Zurückversetzung des Verbindungsabschnitts können dabei der effektive Hebelarm und damit die effektive Federkonstante besonders einfach eingestellt werden.

Durch das nach außen Drücken kann auch zusätzlich der Wärmekontakt zu einem äußeren Gehäuseteil der elektronischen Baugruppe hergestellt oder verbessert werden. Auch dadurch wird die wirksame Kühlfläche vergrößert.

Falls das Gehäuse aus Metall besteht (Schutzklasse I), sind die Klammer und das oder die Kühlbleche vom Gehäuse isoliert.

Die Federwirkung kann sich aber auch aus den Halteabschnitten allein (im allgemeinen aber aus der ganzen Klammer) ergeben.

Ein bevorzugter Anwendungsbereich der Erfindung liegt bei Betriebsschaltungen für Lampen, insbesondere bei elektronischen Konvertern für Halogenlampen und Vorschaltgeräten für Gasentladungslampen. Bei diesen Schaltungen finden Brückenschaltungen aus Leistungstransistoren Verwendung, wobei mit der erfindungsgemäßen Klammer beispielsweise die beiden Transistoren einer Halbbrücke oder auch alle vier Transistoren einer Vollbrücke jeweils mit Kühlblechen verbunden werden können.

Mit der Erfindung können wie im Stand der Technik sowohl für jeden Leistungshalbleiter einzelne Kühlbleche als auch für zwei oder mehr Leistungshalbleiter gemeinsame Kühlbleche verwendet werden. Im letztgenannten Fall werden häufig U-förmige Kühlbleche verwendet, bei denen jeder Schenkel auf einer jeweiligen Seite der Montageplatine durch die Klammer mit dem entsprechenden Leistungshalbleiter verbunden wird. Die Basis des U liegt dabei meistens unter der Montageplatine und sorgt somit bei entsprechendem Anschluß - vorteilhafterweise durch die Klammer selbst und ferner in Verbindung mit der beschriebenen Abschirmfunktion des flächigen Verbindungsabschnitts - für eine zusätzliche (unterseitige) Abschirmung der Schaltung (bezüglich hochfrequenter Störpotentiale). Außerdem wird die Montage weiter vereinfacht. Die beschriebenen U-förmigen Kühlbleche sind allerdings, obwohl sie zwei oder mehr einfache Bleche ersetzen, etwas teurer.

Die praktischen Eigenschaften der Erfindung können weiter verbessert werden durch einen Vorsprung an einer Innenfläche eines Halteabschnitts, also etwa an der Innenseite eines Schenkels der U-Form. Der Vorsprung definiert im montierten Zustand den (möglichst zentralen) Punkt der Krafteinwirkung des entsprechenden Teils des Halteabschnitts und damit der Klammer insgesamt auf das Leistungshalbleitergehäuse und letzlich auch auf das Kühlblech. Auf diese Weise wird ein flächiger Kontakt zwischen Leistungshalbleiter bzw. dessen Kühlfahne einerseits und dem Kühlblech andererseits und folglich ein guter Wärmekontakt zwischen beiden sichergestellt.

Der Vorsprung kann einfach hergestellt werden mit einem stempelähnlichen Werkzeug, mit dem vor dem Biegen der endgültigen Klammerform ein entsprechender Teil des Klammermaterials (gewöhnlich Metall, insbesondere Federstahl) von der anderen Seite her herausgedrückt wird. Durch eine passende Werkzeugkontur wird die gewünschte Form vorgegeben, beispielsweise eine Rampenform mit einer flachen Steigung zur Erleichterung des Aufsetzens der Klammer bei der Montage.

### Beschreibung der Zeichnungen

Im folgenden wird die Erfindung anhand eines Ausführungsbeispiels näher erläutert werden. Es zeigen:
Figur 1 eine erfindungsgemäße Klammer in Seitenansicht,
Figur 2 eine Draufsicht der Klammer aus Figur 1.

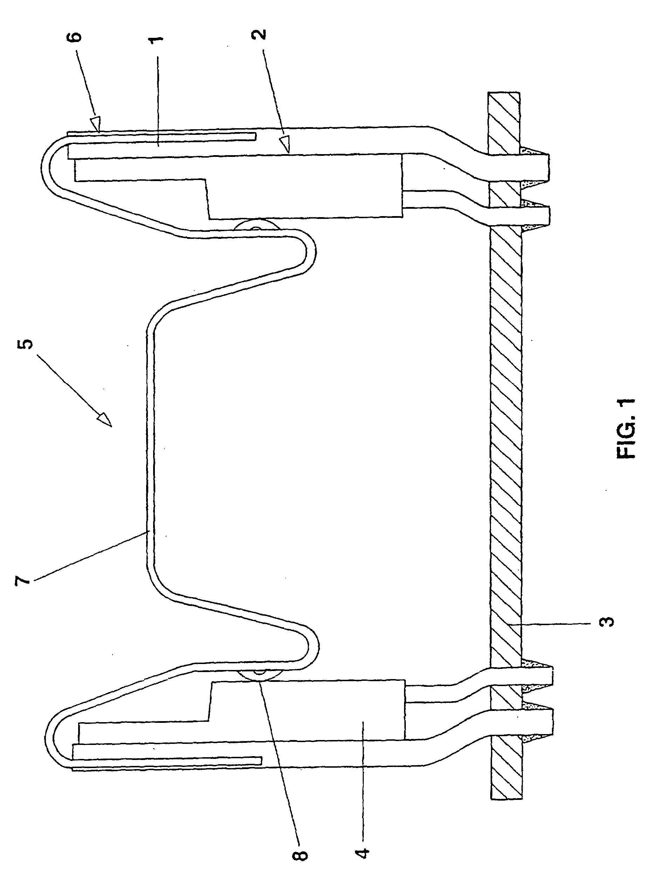

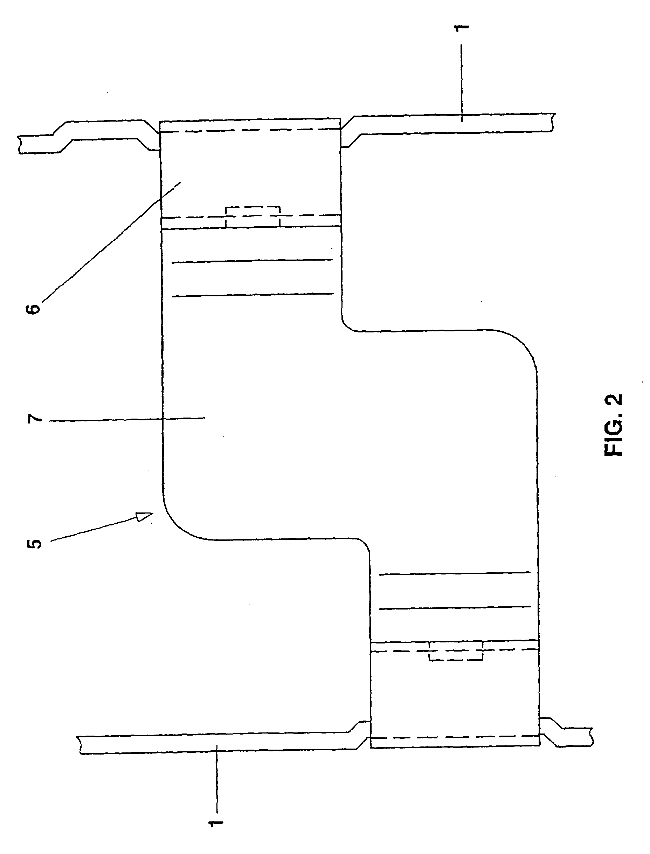

Die Blickrichtung liegt also jeweils in der Ebene der größten Fläche eines von der Klammer gehaltenen Leistungshalbleiters und zusätzlich in Fig. 1 in der Ebene der Montageplatine, in Fig. 2 senkrecht dazu.

In Fig. 1 erkennt man unten eine Montageplatine, genauer eine Leiterplatte 3, auf der am rechten und am linken Rand der Figur mit den üblichen Steckfüßen jeweils ein Leistungshalbleiter, nämlich ein Bipolartransistor 4 mit Kühlfahne (längeres Teil), und ein Kühlblech 1 montiert sind. Auf der unteren Seite enthält die Montageplatine 3 nicht eingezeichnete Leiterbahnen, mit denen die Steckfüße der Leistungshalbleiter 4 von unten wie angedeutet verlötet sind. Die Steckfüße der Kühlbleche 1 sind nicht notwendig, erleichtern aber die Montage, weil die Kühlbleche 1 beim Aufsetzen der im folgenden beschriebenen Klammer 5 nicht festgehalten werden müssen. Sie sind vorteilhafterweise etwas gebogen um bei mechanischer Belastung bei der Montage elastisch nachgeben zu können.

Die Leistungshalbleiter 4 mit ihren Kühlfahnen und die Kühlbleche 1 sind beidseits durch einen (umgekehrt) U-förmigen Halteabschnitt 6 der Klammer 5 zusammengehalten. Dabei liegt hier die Kühlfahne direkt an dem Kühlblech 1 an. Diese Anlage erfolgt im vorliegenden Fall mit der größten Fläche 2 der Leistungshalbleiter 4, die eingangs zur Definition der relativen Lage der Leistungshalbleiter 4 zueinander verwendet wurde.

Auf der Innenseite im unteren Bereich des jeweiligen Innenschenkels der Halteabschnitte 6 ist je ein oben bereits beschriebener Vorsprung 8 in Form eines in einer runden Form herausgebogenen Teils vorgesehen, der am Leistungshalbleiter auf der kühlfahnen- und kühlblechabgewandten Seite anliegt. Die bereits beschriebene Rampenform ist bei diesem Vorsprung 8 nicht verwirklicht.

Auf der an dem höheren Kühlblech 1 anliegenden Seite weist die U-Form der Halteabschnitte 6 einen langgestreckten geraden Verlauf auf.

Zwischen den beiden durch die Halteabschnitte 6 zusammengedrückten Paketen erstreckt sich ein Verbindungsabschnitt 7 der Klammer 5, der im wesentlichen quer verläuft und dabei gegenüber dem unteren offenen Ende der Halteabschnitte durch einen Zwischenbereich nach oben zurückversetzt ist. Dadurch läßt er darunter einen für die Bauhöhe nicht eingezeichneter weiterer Schaltungsteile ausreichenden Spielraum. Im übrigen ist dadurch - wie bereits erwähnt - eine geeignete effektive Federkonstante der Klammer als Ganzes eingestellt. Insgesamt ergibt sich beidseits des geraden Verbindungsabschnittstücks eine doppel-S-ähnliche Form.

Der gerade Teil des Verbindungsabschnitts 7 ist dabei geringfügig nach oben gewölbt (nicht gezeichnet), weil der Abstand zwischen den Außenpunkten der Vorsprünge 8 im unverformten Zustand der Klammer 5 vor dem Aufsetzen gegenüber dem Innenabstand zwischen den Leistungshalbleitern 4 etwas Übermaß hat. Dadurch werden die Leistungshalbleiter 4 nach außen, und zwar gegen die Kühlbleche 1 und die Außenschenkel der Halteabschnitte 6 gedrückt.

In Fig. 2 erkennt man in der Draufsicht die flächige Ausführung des Verbindungsabschnitts 7 mit den geschilderten Funktionen der Verminderung leitungsgebundener Funkstörungen - hier vor allem durch Abschirmung von Störpotentialen gegenüber einem geerdeten metallischen Gehäuse oder der Umgebung - und der Wirkung als weiteres integriertes Kühlblech. Zur Verminderung leitungsgebundener Funkstörungen ist die Klammer 5 auf dem Kollektor- und Kühlfahnenpotential eines der beiden Transistoren 4 und gegenüber dem anderen durch eine in Fig. 1 nicht eingezeichnete zwischengelegte Isolation, etwa eine Hostafanfolie, isoliert. Das Abschirmungspotential entspricht dabei dem nur mit Netzfrequenz modulierten positiven Versorgungspotential der vorliegend angenommenen Bipolartransistor-Halbbrücke.

Fig. 2 zeigt schließlich eine Bauform der Klammer 5, bei der die Pakete aus den Leistungshalbleitern 4 und den Kühlblechen 1 nicht genau gegenüberliegen. Daher hat der Verbindungsabschnitt 7 in der Projektion auf die Ebene der Montageplatine 3 eine diesem Querversatz angepaßte Form eines Doppel-L. Man sieht, daß bei vier Leistungshalbleitern 4 beispielsweise auch eine H-Form oder bei zwei Leistungshalbleitern auch eine einfache gerade Form möglich wäre.

## Patentansprüche

1. Verfahren zur Verbindung zumindest eines Kühlblechs (1) mit zumindest zwei mit ihrer größten Fläche (2) in verschiedenen Ebenen liegenden, im wesentlichen senkrecht auf einer Montageplatine (3) montierten Leistungshalbleitern (4), bei dem das Kühlblech und eine jeweilige Fläche der Leistungshalbleiter durch die Federkraft einer Klammer (5) planar aneinander gedrückt werden, wobei die Verbindung mit nur einer Klammer (5) erfolgt, die Halteabschnitte (6) für jeweils einen Leistungshalbleiter (4) und einen Verbindungsabschnitt (7) zwischen den Halteabschnitten aufweist, **dadurch gekennzeichnet, daß** jeder Halteabschnitt (6) zwei Schenkel aufweist, die geeignet sind zum planaren Aneinanderdrücken des Kühlblechs (1) und einer jeweilige Fläche der Leistungshalbleiter (4) zwischen den Schenkeln des betreffenden Halteabschnitts (1).

2. Verfahren nach Anspruch 1, bei dem der Verbindungsabschnitt (7) gegenüber dem der Montageplatine (3) zugewandten Ende der Halteabschnitte (6) zurückversetzt ist.

3. Verfahren nach Anspruch 1 oder 2, bei dem der Verbindungsabschnitt (7) zur Wärmeabstrahlung und/oder zur Verminderung leitungsgebundener Funkstörungen im montierten Zustand zwischen ihm und der Montageplatine (3) angeordneter Schaltungsteile flächig ausgeführt ist.

4. Verfahren nach einem der vorstehenden Ansprüche, bei dem zumindest ein Halteabschnitt (6) mit integriertem Kühlblech ausgeführt ist.

5. Verfahren nach einem der vorstehenden Ansprüche, bei dem die Klammer (5) mit einem Leistungshalbleiteranschluß auf im wesentlichen konstantem Potential elektrisch leitend verbunden, gegenüber anderen Potentialen aber elektrisch isoliert angebracht ist.

6. Verfahren nach einem der vorstehenden Ansprüche, bei dem der Abstand zwischen den Halteabschnitten (6) ein leichtes Übermaß und der Verbindungsabschnitt federnde Eigenschaften hat.

7. Verfahren nach einem der vorstehenden Ansprüche, bei dem die auf der Montageplatine (3) montierten Leistungshalbleiter (4) Brückentransistoren eines elektronischen Konverters oder elektronischen Vorschaltgeräts zum Lampenbetrieb sind.

8. Verfahren nach einem der vorstehenden Ansprüche, bei dem an einer Innenseite eines Halteabschnitts (6) ein Vorsprung (8) ausgebildet ist.

9. Verfahren nach Anspruch 8, bei dem der Vorsprung (8) aus der Innenseitenoberfläche herausgedrückt ist.

10. Verfahren nach Anspruch 8 oder 9, bei dem der Vorsprung (8) eine für das Aufsetzen auf den Leistungshalbleiter (4) bzw. das Kühlblech (1) flache und zu der entgegengesetzten Seite steile Rampenform hat.

11. Klammer (5) mit zumindest zwei Halteabschnitten (6) mit je zwei Schenkeln zum planaren Aneinanderdrücken einer Fläche jeweils eines von zumindest zwei mit ihrer größten Fläche (2) in verschiedenen Ebenen liegenden, im wesentlichen senkrecht auf einer Montageplatine (3) montierten Leistungshalbleitern (4) und eines Kühlblechs (1) zwischen den Schenkeln des Halteabschnitts und mit einem die Halteabschnitte verbindenden Verbindungsabschnitt (7), der sich in einer zu den Schenkeln der Halteabschnitte im wesentlichen senkrechten Ebene erstreckt.

12. Klammer (5) nach Anspruch 11, bei der der Verbindungsabschnitt (7) gegenüber einem offenen Ende der Halteabschnitte (6) zurückversetzt ist.

13. Klammer (5) nach einem der Ansprüche 11 oder 12, bei der der Verbindungsabschnitt (7) zur Wärmeabstrahlung und/oder zur Verminderung leitungsgebundener Funkstörungen im montierten Zustand zwischen ihm und der Montageplatine (3) angeordneter Schaltungsteile flächig ausgeführt ist.

14. Klammer (5) nach einem der Ansprüche 11 bis 13, bei der zumindest ein Halteabschnitt (6) mit integriertem Kühlblech ausgeführt ist.

15. Klammer (5) nach einem der Ansprüche 11 bis 14, bei der an der Innenseite eines Halteabschnittschenkels ein Vorsprung (8) ausgebildet ist.

16. Klammer (5) nach einem der Ansprüche 11 bis 15, bei der der Vorsprung (8) aus der Innenseitenoberfläche herausgedrückt ist.

17. Klammer (5) nach einem der Ansprüche 11 bis 16, bei der der Vorsprung (8) die Form einer zu dem offenen Ende der Halteabschnitte (6) hin flach und zu der entgegengesetzten Seite steil ansteigenden Rampe hat.

18. Elektronische Baugruppe mit zumindest zwei Leistungshalbleitern (4) und einem Kühlblech (1) und mit einer das Kühlblech und die Leistungshalbleiter aneinander drückenden Klammer (5) nach einem der Ansprüche 11 bis 17.

19. Elektronische Baugruppe nach Anspruch 18, bei der der Abstand zwischen den Halteabschnitten (6) ein leichtes Übermaß und der Verbindungsabschnitt (7) federnde Eigenschaften hat.

20. Elektronische Baugruppe nach Anspruch 18 oder 19, bei der die Klammer (5) mit einem Leistungshalbleiteranschluß auf im wesentlichen konstantem Potential elektrisch leitend verbunden, gegenüber anderen Potentialen aber elektrisch isoliert angebracht ist.

21. Elektronische Baugruppe nach einem der Ansprüche 18 bis 20, bei der die auf der Montageplatine (3) montierten Leistungshalbleiter (4) Brükkentransistoren eines elektronischen Konverters oder elektronischen Vorschaltgeräts zum Lampenbetrieb sind.

## Claims

1. Method for connecting at least one cooling plate (1) to at least two power semiconductors (4), which lie with their largest surface (2) in different planes and are mounted essentially vertically on a mounting board (3), in which method the cooling plate and a respective surface of the power semiconductors are pressed against one another in a planar manner by the spring force of a clip (5), the connection being effected using just one clip (5), which has holding sections (6) for a respective power semiconductor (4) and a connecting section (7) between the holding sections, **characterized in that** each holding section (6) has two limbs suitable for pressing against one another, in a planar manner, the cooling plate (1) and a respective surface of the power semiconductors (4) between the limbs of the relevant holding section (1).

2. Method according to Claim 1, in which the connecting section (7) is set back with respect to that end of the holding sections (6) which faces the mounting board (3).

3. Method according to Claim 1 or 2, in which the connecting section (7) is of planar design serving the purpose of heat radiation and/or the reduction of conducted radio interference of circuit sections arranged between it and the mounting board (3) in the mounted state.

4. Method according to one of the preceding claims, in which at least one holding section (6) is designed with an integrated cooling plate.

5. Method according to one of the preceding claims, in which the clip (5) is electrically conductively connected to a power semiconductor terminal at an essentially constant potential, but is fitted such that it is electrically insulated from other potentials.

6. Method according to one of the preceding claims, in which the distance between the holding sections (6) has a slight oversize and the connecting section has resilient properties.

7. Method according to one of the preceding claims, in which the power semiconductors (4) mounted on the mounting board (3) are bridge transistors of an electronic converter or electronic ballast for the operation of lamps.

8. Method according to one of the preceding claims, in which a projection (8) is formed on an inner side of a holding section (6).

9. Method according to Claim 8, in which the projection (8) is pressed out from the surface of the inner side.

10. Method according to Claim 8 or 9, in which the projection (8) has a ramp shape which is gently inclined for emplacement on the power semiconductor (4) and/or the cooling plate (1) and steep on the opposite side.

11. Clip (5) having at least two holding sections (6) each having two limbs for pressing against one another, in a planar manner, a respective surface of one of at least two power semiconductors (4), which lie which their largest surface (2) in different planes and are mounted essentially vertically on a mounting board (3), and of a cooling plate (1) between the limbs of the holding section, and having a connecting section (7), which connects the holding sections and extends in a plane which is essentially perpendicular to the limbs of the holding sections.

12. Clip (5) according to Claim 11, in which the connecting section (7) is set back with respect to an open end of the holding sections (6).

13. Clip (5) according to either of Claims 11 and 12, in which the connecting section (7) is of planar design serving the purpose of heat radiation and/or the reduction of conducted radio interference of circuit sections arranged between it and the mounting board (3) in the mounted state.

14. Clip (5) according to one of Claims 11 to 13, in which at least one holding section (6) is designed with an integrated cooling plate.

15. Clip (5) according to one of Claims 11 to 14, in which a projection (8) is formed on the inner side of a holding-section limb.

16. Clip (5) according to one of Claims 11 to 15, in which the projection (8) is pressed out from the surface of the inner side.

17. Clip (5) according to one of Claims 11 to 16, in which the projection (8) has the shape of a ramp rising gently towards the open end of the holding sections (6) and steeply on the opposite side.

18. Electronic assembly having at least two power semiconductors (4) and a cooling plate (1) and having a clip (5), according to one of Claims 11 to 17, which presses the cooling plate and the power semiconductors against one another.

19. Electronic assembly according to Claim 18, in which the distance between the holding sections (6) has a slight oversize and the connecting section (7) has resilient properties.

20. Electronic assembly according to Claim 18 or 19, in which the clip (5) is electrically conductively connected to a power semiconductor terminal at an essentially constant potential, but is fitted such that it is electrically insulated from other potentials.

21. Electronic assembly according to one of Claims 18 to 20, in which the power semiconductors (4) mounted on the mounting board (3) are bridge transistors of an electronic converter or electronic ballast for the operation of lamps.

## Revendications

1. Procédé d'assemblage d'au moins une ailette (1) de refroidissement à au moins deux semi-conducteurs (4) de puissance, dont les surfaces (2) les plus grandes se trouvent dans des plans différents et qui sont montés sensiblement perpendiculairement à une platine (3) de montage, dans lequel on repousse l'une vers l'autre à plat l'ailette de refroidissement et une surface respective du semi-conducteur par la force élastique d'une agrafe (5), l'assemblage s'effectuant par seulement une agrafe qui a des tronçons (6) de maintien pour, respectivement, un semi-conducteur (4) de puissance et un tronçon (7) de liaison entre les tronçons de maintien, **caractérisé en ce que** chaque tronçon (6) de maintien a deux branches qui sont appropriées à l'application à plat l'une sur l'autre de l'ailette (1) de refroidissement et d'une surface respective du semi-conducteur (4) de puissance entre les branches du tronçon (6) de maintien concerné.

2. Procédé suivant la revendication 1, dans lequel le tronçon (7) de liaison est décalé par rapport à l'extrémité du tronçon (6) de maintien, qui est tournée vers la platine (3) de montage.

3. Procédé suivant la revendication 1 ou 2, dans lequel le tronçon (7) de liaison est réalisé en ayant une surface pour l'évacuation de la chaleur par rayonnement et/ou pour diminuer les parasites liés à la ligne à l'état monté entre lui et des parties de circuit disposées sur la platine (3) de montage.

4. Procédé suivant l'une des revendications précédentes, dans lequel au moins un tronçon (6) de maintien est réalisé en ayant une ailette de refroidissement intégrée.

5. Procédé suivant l'une des revendications précédentes, dans lequel l'agrafe (5) est reliée à une borne de semi-conducteur de puissance de manière conductrice de l'électricité à un potentiel sensiblement constant, mais en étant isolée électriquement vis-à-vis d'autres potentiels.

6. Procédé suivant l'une des revendications précédentes, dans lequel la distance entre les tronçons (6) de maintien a un léger excès et le tronçon de liaison a des propriétés élastiques.

7. Procédé suivant l'une des revendications précédentes, dans lequel les semi-conducteurs (4) de puissance montés sur la platine (3) de montage sont des transistors à pont d'un convertisseur électronique ou d'un ballast électronique pour le fonctionnement d'une lampe.

8. Procédé suivant l'une des revendications précédentes, dans lequel il est constitué une saillie (8) sur un côté intérieur d'un tronçon (6) de maintien.

9. Procédé suivant la revendication 8, dans lequel la saillie (8) est obtenue par refoulement de la surface latérale intérieure.

10. Procédé suivant la revendication 8 ou 9, dans lequel la saillie (8) a une forme en rampe plate pour s'appliquer sur le semi-conducteur (4) de puissance ou sur l'ailette (1) de refroidissement et abrupte du côté opposé.

11. Agrafe (5) ayant au moins deux tronçons (6) de maintien comprenant chacun deux branches pour repousser l'une vers l'autre à plat une surface de, respectivement, l'un d'au moins deux semi-conducteurs (4) de puissance, dont les surfaces (2) les plus grandes sont dans des plans différents et qui sont montés sensiblement perpendiculairement à une platine (3) de montage et une ailette (1) de refroidissement entre les branches du tronçon de maintien et comprenant un tronçon (7) de liaison reliant les tronçons de maintien et s'étendant dans un plan sensiblement perpendiculaire aux branches des tronçons de maintien.

12. Agrafe (5) suivant la revendication 11, dans lequel le tronçon (7) de liaison est en retrait par rapport à une extrémité ouverte des tronçons (6) de maintien.

13. Agrafe (5) suivant l'une des revendications 11 ou 12, dans lequel le tronçon (7) de maintien est réalisé en ayant une surface pour l'évacuation de la chaleur par rayonnement et/ou pour diminuer les parasites liés à la ligne à l'état monté entre lui et des parties de circuit disposées sur la platine (3) de montage.

14. Agrafe (5) suivant l'une des revendications 11 à 13, dans lequel au moins un tronçon (6) de maintien est réalisé en ayant une ailette de refroidissement intégrée.

15. Agrafe (5) suivant l'une des revendications 11 à 14, dans lequel il est constitué une saillie (8) sur un côté intérieur d'un tronçon (6) de maintien.

16. Agrafe (5) suivant l'une des revendications 11 à 15, dans lequel la saillie (8) est obtenue par refoulement de la surface latérale intérieure.

17. Agrafe (5) suivant l'une des revendications 11 à 16, dans lequel la saillie (8) a une forme en rampe plate pour s'appliquer sur le semi-conducteur (4) de puissance ou sur l'ailette (1) de refroidissement et abrupte du côté opposé.

18. Module électronique comprenant au moins deux semi-conducteurs (4) de puissance et une ailette (1) de refroidissement et une agrafe (5) suivant l'une des revendications 11 à 17, repoussant l'une vers les autres l'ailette de refroidissement et les semi-conducteurs de puissance.

19. Module électronique suivant la revendication 18, dans lequel la distance entre les tronçons (6) de maintien a un léger excès et le tronçon de liaison a des propriétés élastiques.

20. Module électronique suivant la revendication 18 ou 19, dans lequel l'agrafe (5) est reliée à une bande de semi-conducteurs de puissance de manière conductrice de l'électricité à un potentiel sensiblement constant, mais en étant isolée électriquement vis-à-vis d'autres potentiels.

21. Module électronique suivant l'une des revendications 18 à 20, dans lequel les semi-conducteurs (4) de puissance montés sur la platine (3) de montage sont des transistors à pont d'un convertisseur électronique ou d'un ballast électronique pour le fonctionnement d'une lampe.
